# EUROPEAN PATENT APPLICATION

(11) **EP 4 564 535 A1**
(43) Date of publication of application: **04.06.2025**
(21) Application number: 24208722.9
(22) Date of filing: 24.10.2024
(51) Int. Cl.: H01M 10/6568

(54) **THERMAL MANAGEMENT SYSTEM, ENERGY STORAGE DEVICE, AND PHOTOVOLTAIC ENERGY STORAGE SYSTEM**

(30) Priority: 30.11.2023 CN 202311636748
(71) Applicant: Huawei Digital Power Technologies Co., Ltd., Shenzhen, Guangdong 518043 (CN)
(72) Inventor: HUANG, Tao, Shenzhen, Guangdong (CN); LI, Malin, Shenzhen, Guangdong (CN); MENG, Hao, Shenzhen, Guangdong (CN); GUO, Zhengdao, Shenzhen, Guangdong (CN); LIU, Huang, Shenzhen, Guangdong (CN); ZHANG, Kun, Shenzhen, Guangdong (CN)
(74) Representative: Maiwald GmbH

(57) **Abstract**

This application relates to the field of energy technologies, and discloses a thermal management system, an energy storage device, and a photovoltaic energy storage system, to improve integration of the thermal management system. The thermal management system includes a first path, a second path, a third path, a fourth path, and a multi-way valve. A first port and a second port of the multi-way valve are respectively communicated with an inlet and an outlet of the first path, and the first path includes a coolant flow channel of an evaporator. A third port and a fourth port are respectively communicated with an inlet and an outlet of the second path, the second path includes a coolant flow channel of a condenser, a first liquid outlet, and a first liquid inlet, and the first liquid outlet and the first liquid inlet are separately configured to connect to a first cold plate. A fifth port and a sixth port are respectively communicated with an inlet and an outlet of the third path, the third path includes a second liquid outlet and a second liquid inlet, and the second liquid outlet and the second liquid inlet are separately configured to connect to a second cold plate. A seventh port and an eighth port are respectively communicated with an inlet and an outlet of the fourth path, and the fourth path includes a heat exchanger.

## Description

### TECHNICAL FIELD

This application relates to the field of energy technologies, and in particular, to a thermal management system, an energy storage device, and a photovoltaic energy storage system.

### BACKGROUND

With the continuous development of clean energy, energy storage devices for storing electric energy are widely used in a plurality of fields. Currently, there are more large cabinet-level or container-level energy storage devices, and an electric energy storage capability of the energy storage device can be improved by configuring more batteries.

A thermal management system is generally configured in the energy storage device to perform thermal management on loads such as a battery and a power module in the device, so that temperatures of the battery, the power module, and the like can be kept within a proper temperature range, to ensure normal running of the energy storage device. To satisfy cold and hot requirements of the energy storage device in different scenarios, the thermal management system generally needs to have a plurality of working modes. Currently, the thermal management system generally implements mode switching by controlling a plurality of three-way valves by using a plurality of motors. This design leads to a complex structure and a scattered layout of the thermal management system.

### SUMMARY

This application provides a thermal management system, an energy storage device, and a photovoltaic energy storage system, to simplify a structure of the thermal management system and improve integration of the thermal management system.

According to a first aspect, this application provides a thermal management system. The thermal management system includes a first path, a second path, a third path, a fourth path, and a multi-way valve. The first path, the second path, the third path, and the fourth path are all configured to flow coolant, and the multi-way valve includes a first port, a second port, a third port, a fourth port, a fifth port, a sixth port, a seventh port, and an eighth port. The first port and the second port are respectively connected to an inlet and an outlet of the first path, the first path includes a coolant flow channel of an evaporator, the inlet of the first path is connected to an inlet of the coolant flow channel of the evaporator, and an outlet of the coolant flow channel of the evaporator is connected to the outlet of the first path. The third port and the fourth port are respectively connected to an inlet and an outlet of the second path, the second path includes a coolant flow channel of a condenser, a first liquid outlet, and a first liquid inlet, the first liquid outlet is configured to connect to a liquid inlet of a first cold plate, the first liquid inlet is configured to connect to a liquid outlet of the first cold plate, the inlet of the second path is connected to the first liquid outlet, the first liquid inlet is connected to an inlet of the coolant flow channel of the condenser, and an outlet of the coolant flow channel of the condenser is connected to the outlet of the second path. The fifth port and the sixth port are respectively connected to an inlet and an outlet of the third path, the third path includes a second liquid outlet and a second liquid inlet, the second liquid outlet is configured to connect to a liquid inlet of a second cold plate, the second liquid inlet is configured to connect to a liquid outlet of the second cold plate, the inlet of the third path is connected to the second liquid outlet, and the second liquid inlet is connected to an outlet of the third path. The seventh port and the eighth port are respectively connected to an inlet and an outlet of the fourth path, the fourth path includes a heat exchanger, the inlet of the fourth path is connected to an inlet of the heat exchanger, and an outlet of the heat exchanger is connected to the outlet of the fourth path. The multi-way valve is configured to communicate the first port with the sixth port or communicate the first port with the eighth port, the multi-way valve is configured to communicate the second port with the fifth port or communicate the second port with the seventh port, the multi-way valve is configured to communicate the third port with the eighth port or communicate the third port with the sixth port, and the multi-way valve is configured to communicate the fourth port with the seventh port or communicate the fourth port with the fifth port.

In this application, the thermal management system is divided into four independent paths, and every two ports of the multi-way valve are configured to connect to one of the paths. Therefore, different modes of connection between the four paths can be implemented by controlling a status of communication between the ports of the multi-way valve, so that a plurality of different circulation loops can be formed between the four paths, to provide feasibility for the thermal management system to implement a plurality of working modes. In addition, the multi-way valve is configured to establish connection relationships between the four paths, so that integration of the thermal management system can be improved, and connection pipelines of the thermal management system can be simplified. This helps improve energy efficiency of the thermal management system.

In some implementation solutions, the thermal management system further includes a first pump and a second pump. The first pump and the second pump may be separately connected to two of the foregoing four paths, to drive the coolant to circulate in a circulation loop formed by connecting different paths, to improve heat exchange efficiency of the thermal management system.

For example, in an implementation, the first pump is connected to the first path, an inlet of the first pump is connected to the inlet of the first path, and an outlet of the first pump is connected to the inlet of the coolant flow channel of the evaporator; or an inlet of the first pump is connected to the outlet of the coolant flow channel of the evaporator, and an outlet of the first pump is connected to the outlet of the first path. The second pump is connected to the second path, an inlet of the second pump is connected to the inlet of the second path, and an outlet of the second pump is connected to the first liquid outlet, or an inlet of the second pump is connected to the outlet of the coolant flow channel of the condenser, and an outlet of the second pump is connected to the outlet of the second path. The first pump and the second pump are respectively connected to the first path and the second path, so that circulation loops run by the thermal management system in different working modes each include at least one pump, to improve heat exchange efficiency of the circulation loops.

For another example, in another implementation, the first pump is connected to the fourth path, an inlet of the first pump is connected to the inlet of the fourth path, and an outlet of the first pump is connected to the inlet of the heat exchanger, or an inlet of the first pump is connected to the outlet of the heat exchanger, and an outlet of the first pump is connected to the outlet of the fourth path. The second pump is connected to the third path, an inlet of the second pump is connected to the inlet of the third path, and an outlet of the second pump is connected to the second liquid outlet; or an inlet of the second pump is connected to the second liquid inlet, and an outlet of the second pump is connected to the outlet of the third path. The first pump and the second pump are respectively connected to the fourth path and the third path, so that circulation loops run by the thermal management system in different working modes each can also include at least one pump, to improve heat exchange efficiency of the circulation loops.

In some implementation solutions, the thermal management system further includes a liquid refill pot. In an implementation, the liquid refill pot may be connected to the second path, and the liquid refill pot is closer to the third port than the second liquid outlet, or the liquid refill pot is closer to the fourth port than the outlet of the coolant flow channel of the condenser. In another implementation, the liquid refill pot may alternatively be connected to the fourth path, and the liquid refill pot is closer to the seventh port than the inlet of the heat exchanger, or the liquid refill pot is closer to the eighth port than the outlet of the heat exchanger. The foregoing connection manner is used, so that the liquid refill pot can not only implement a liquid refill function for each circulation loop of the thermal management system, but also stabilizes a voltage inside the multi-way valve, to improve working stability of the multi-way valve in different connection states.

In some implementation solutions, the thermal management system may further include an electric heater. In an implementation, the electric heater is connected to the third path, an inlet of the electric heater is connected to the inlet of the third path, and an outlet of the electric heater is connected to the second liquid outlet. When the second cold plate is connected to the third path, the electric heater may heat, in a low-temperature scenario, coolant entering the second cold plate, to implement a heating function for the second load by using the cold plate.

In another implementation, the electric heater may alternatively be connected to the second path, an inlet of the electric heater is connected to the outlet of the coolant flow channel of the condenser, and an outlet of the electric heater is connected to the outlet of the second path. In this way, when the second path and the third path are connected to form a circulation loop, the electric heater may also be located upstream of the second cold plate, to heat coolant entering the second cold plate and implement a heating function for the second load.

In some implementation solutions, the thermal management system further includes a fifth path, and the fifth path is configured to flow a refrigerant. The fifth path includes a compressor, an expansion valve, a refrigerant flow channel of the condenser, and a refrigerant flow channel of the evaporator, an outlet of the compressor is connected to an inlet of the refrigerant flow channel of the condenser, an outlet of the refrigerant flow channel of the condenser is connected to an inlet of the refrigerant flow channel of the evaporator through the expansion valve, and an outlet of the refrigerant flow channel of the evaporator is connected to an inlet of the compressor. It can be seen that, the fifth path may form a complete compressor drive circulation loop, and the thermal management system may implement heating or cooling by running the fifth path, to meet working requirements of the thermal management system in different scenarios.

In some implementation solutions, the fifth path further includes a dehumidification module. An inlet of the dehumidification module is connected to the outlet of the refrigerant flow channel of the condenser, and an outlet of the dehumidification module is connected to the inlet of the compressor. Therefore, the compressor, the refrigerant flow channel of the condenser, and the dehumidification module may be sequentially connected to form a circulation loop. The thermal management system may reduce humidity inside the energy storage device by running the circulation loop, to reduce a risk of corrosion of the first load, the second load, and another electrical component.

For example, the dehumidification module includes a second evaporator and a second expansion valve. An outlet of the second expansion valve is connected to an inlet of the second evaporator, an inlet of the second expansion valve may be used as the inlet of the dehumidification module, and an outlet of the second evaporator may be used as the outlet of the dehumidification module. In this way, the dehumidification module can be connected to a corresponding circulation loop by connecting the outlet of the refrigerant flow channel of the condenser to the inlet of the second expansion valve and connecting the outlet of the second evaporator to the inlet of the compressor.

In some implementation solutions, in a first scenario, the multi-way valve is configured to communicate the first port with the sixth port, communicate the second port with the fifth port, communicate the third port with the eighth port, and communicate the fourth port with the seventh port. In this case, the first path and the third path may be connected to form a first circulation loop, and the second path and the fourth path may be connected to form a second circulation loop. In the first circulation loop, the coolant flow channel of the evaporator can cool the coolant, and the second cold plate can cool the second load by using the cooled coolant. In the second circulation loop, the heat exchanger can cool the coolant, and the first cold plate can cool the first load by using the cooled coolant. Therefore, in this scenario, the thermal management system may separately dissipate heat for the first load and the second load by running the first circulation loop and the second circulation loop.

In some implementation solutions, in a second scenario, the multi-way valve is configured to communicate the first port with the eighth port, communicate the second port with the fifth port, communicate the third port with the sixth port, and communicate the fourth port with the seventh port. In this case, the first path, the third path, the second path, and the fourth path may be connected to form a third circulation loop. In the third circulation loop, the heat exchanger can cool the coolant. The cooled coolant first enters the second cold plate, so that the second cold plate cools the second load, and then flows from the second cold plate to the first cold plate, so that the first cold plate cools the first load. Therefore, in this scenario, the thermal management system can dissipate heat for the first load and the second load by running the third circulation loop. It should be noted that, although a temperature of the coolant increases after the coolant exchanges heat with the second load in the second cold plate, compared with a temperature of the first load, the coolant flowing out of the second cold plate is still in a low temperature range. Therefore, the coolant may continue to dissipate heat for the first load.

In some implementation solutions, in a third scenario, the multi-way valve is configured to communicate the first port with the eighth port, communicate the second port with the seventh port, communicate the third port with the sixth port, and communicate the fourth port with the fifth port. In this case, the first path and the fourth path may be connected to form a fourth circulation loop, and the second path and the third path may be connected to form a fifth circulation loop. In the fourth circulation loop, the heat exchanger can heat the coolant, and the coolant flow channel of the evaporator can heat the refrigerant in the refrigerant flow channel of the evaporator. In the fifth circulation loop, the coolant flow channel of the condenser can heat the coolant, and the heated coolant first enters the second cold plate, so that the second cold plate heats the second load. In this case, the temperature of the coolant decreases, and the cooled coolant enters the first cold plate from the second cold plate, so that the first cold plate cools the first load. Therefore, in this scenario, the thermal management system may heat the first load and dissipate heat for the second load by running the fourth circulation loop and the fifth circulation loop.

According to a second aspect, this application further provides an energy storage device, where the energy storage device includes a first load, a second load, a first cold plate, a second cold plate, and the thermal management system in any implementation solution of the first aspect. The first liquid outlet in a second path is connected to a liquid inlet of the first cold plate, and the first liquid inlet in the first path is connected to a liquid outlet of the first cold plate, so that the first cold plate is connected to the second path, and the first cold plate is configured to perform heat exchange with the first load. The second liquid outlet in the third path is connected to a liquid inlet of the second cold plate, and the second liquid inlet in the third path is connected to a liquid outlet of the second cold plate, so that the second cold plate is connected to the third path, and the second cold plate is configured to perform heat exchange with the second load. When running in different working modes, the thermal management system may adjust temperatures of coolant flowing through the first cold plate and the second cold plate, to implement thermal management on the first load and the second load, and improve running energy efficiency of the energy storage device.

In some implementation solutions, the first load is a power module, and the second load is a battery module.

In an implementation, the first cold plate and the power module may be independent of each other, and the first cold plate is in heat conduction contact with the power module, to dissipate heat for the power module. In another implementation, the first cold plate may alternatively be integrated into the power module. Similarly, the second cold plate may be independent of the battery module, or the second cold plate may be integrated into the battery module.

According to a third aspect, this application further provides a photovoltaic energy storage system, where the photovoltaic energy storage system includes a photovoltaic power generation device, a power conversion device, and the energy storage device in the second aspect. The power device is connected between the photovoltaic power generation device and the energy storage device. The photovoltaic power generation device is configured to generate a direct current, and the power conversion device is configured to convert the direct current generated by the photovoltaic power generation device into an alternating current and transmit the alternating current to the energy storage device, to store electric energy by using the energy storage device.

### BRIEF DESCRIPTION OF DRAWINGS

FIG. 1 is a diagram of an application scenario of an energy storage device according to an embodiment of this application;
FIG. 2 is a diagram of another application scenario of an energy storage device according to an embodiment of this application;
FIG. 3 is a diagram of a structure of an energy storage device according to an embodiment of this application;
FIG. 4 is a diagram of a structure of a thermal management system according to an embodiment of this application;
FIG. 5 is a diagram of the thermal management system shown in FIG. 4 running in a compressor cooling mode;
FIG. 6 is a diagram of the thermal management system shown in FIG. 4 running in a compressor cooling and dehumidification mode;
FIG. 7 is a diagram of the thermal management system shown in FIG. 4 running in a natural heat dissipation mode;
FIG. 8 is a diagram of the thermal management system shown in FIG. 4 running in a natural heat dissipation and dehumidification mode;
FIG. 9 is a diagram of the thermal management system shown in FIG. 4 running in a heating mode;
FIG. 10 is a diagram of the thermal management system shown in FIG. 4 running in a heating and dehumidification mode;
FIG. 11 is a diagram of a structure of another thermal management system according to an embodiment of this application;
FIG. 12 is a diagram of a structure of another thermal management system according to an embodiment of this application; and
FIG. 13 is a diagram of a structure of another thermal management system according to an embodiment of this application.

Reference numerals:
1000: energy storage device; 100: cabinet body; 200: battery module; 210: second cold plate; 300: power module; 310: first cold plate;
400: thermal management system; 410: evaporator and first evaporator; 420: condenser; 430: heat exchanger; 440: multi-way valve; 450: first pump;
460: second pump; 470: electric heater; 480: liquid refill pot; 490: compressor; 4100: expansion valve and first expansion valve; 4110: dehumidification module;
4111: second evaporator; 4112: second expansion valve; 4120: gas-liquid separator;
A: first path; B: second path; C: third path; D: fourth path; E: fifth path;
a: first liquid outlet; b: first liquid inlet; c: second liquid outlet; d: second liquid inlet;
v1: first valve port; v2: second valve port; v3: third valve port; v4: fourth valve port; v5: fifth valve port; v6: sixth valve port; v7: seventh valve port; and
v8: eighth valve port.

### DESCRIPTION OF EMBODIMENTS

To make the objectives, technical solutions, and advantages of this application clearer, the following further describes embodiments of this application in detail with reference to the accompanying drawings. However, example implementations may be implemented in a plurality of forms, and should not be construed as being limited to implementations described herein. Identical reference numerals in the accompanying drawings denote identical or similar structures. Therefore, repeated description thereof is omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate a relative position relationship and do not represent an actual scale.

It should be noted that specific details are set forth in the following description to facilitate understanding of this application. However, embodiments of this application can be implemented in a plurality of manners different from those described herein, and a person skilled in the art can perform similar promotion without departing from the connotation of embodiments of this application. Therefore, this application is not limited to the specific implementations disclosed in the following.

An energy storage device is a device that can store electric energy by using a specific medium and release the stored energy to generate electricity when necessary. The energy storage device may be used in five types of industrial and commercial energy storage scenarios such as small industrial and commercial industries (such as small factories), medium industrial and commercial industries, large industrial and commercial industries, integration of optical storage charging stations, and small and medium microgrids (such as islands), and three types of power station scenarios such as wind/solar energy storage power stations, grid energy storage power stations, and large microgrids.

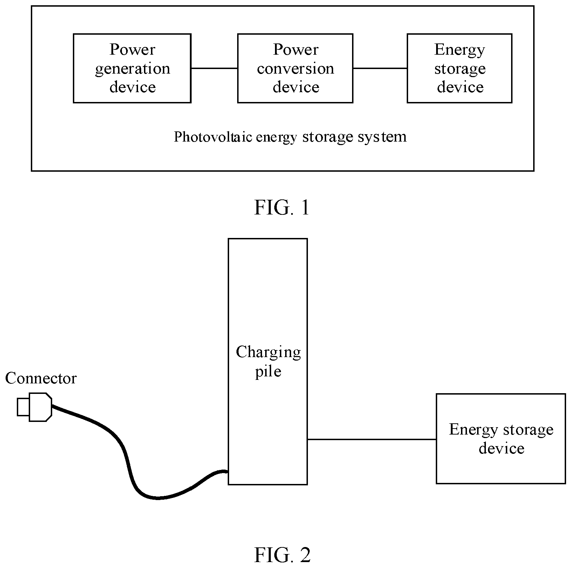

FIG. 1 is a diagram of an application scenario of an energy storage device according to an embodiment of this application. The application scenario is described by using a photovoltaic energy storage system as an example. The photovoltaic energy storage system may include a power conversion device, a power generation device, and an energy storage device. The power conversion device is connected between the power generation device and the energy storage device. The power generation device is configured to generate a direct current, and the power conversion device is configured to convert the direct current generated by the power generation device into an alternating current and transmit the alternating current to the energy storage device.

In some embodiments, the power generation device may be a photovoltaic power generation device, and the photovoltaic power generation device may be configured to convert light energy into direct current energy.

In some embodiments, the power generation device may be a wind power generation device, and the wind power generation device may be configured to convert wind power into direct current power.

FIG. 2 is a diagram of another application scenario of an energy storage device according to an embodiment of this application. The application scenario is described by using a charging network as an example. The charging network includes a charging pile and an energy storage device. The charging pile is electrically connected to the energy storage device through a cable, and the energy storage device may supply electric energy stored in the energy storage device to the charging pile. The charging pile has a connector, and the connector may be connected to a powered device (like a vehicle), to charge the powered device.

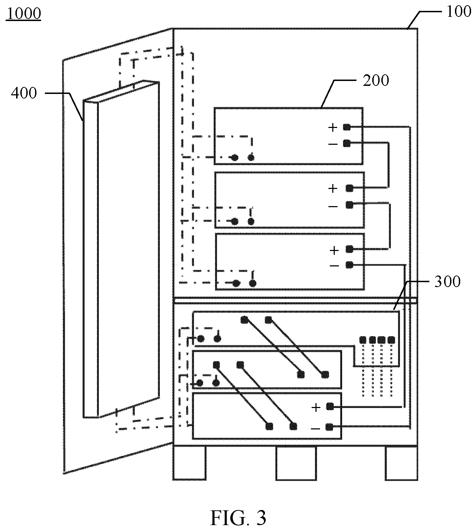

In addition, in embodiments of this application, based on different requirements of application scenarios on power consumption, energy storage devices may be classified into cabinet-level energy storage devices and container-level energy storage devices. FIG. 3 is a diagram of a structure of an energy storage device 1000 according to an embodiment of this application. This embodiment is described by using a cabinet-level energy storage device as an example. The energy storage device 1000 may include a cabinet body 100, a battery module 200, and a power module 300. Both the battery module 200 and the power module 300 may be accommodated in the cabinet body 100. The battery module 200 is a basic unit for the energy storage device to store and release electric energy. The power module 300 may be configured to control a charging/discharging process of a battery. For example, the power module 300 may include a power conversion system (power conversion system, PCS) or a direct current to direct current converter (DC-DC converter, DC/DC). The PCS may be configured to convert an alternating current into a direct current and then provide the direct current for the battery, or convert a direct current from the battery into an alternating current and then output the alternating current. The DC/DC converter may be configured to boost a voltage of the battery module 200, to ensure that a total voltage of the battery module 200 is not lower than a rated voltage, and improve running stability of the battery module 200.

In the foregoing energy storage device, the battery module 200 and the power module 300 are main heat loads in the energy storage device, and temperatures of the battery module 200 and the power module 300 are important conditions for normal running of the energy storage device 1000. For the battery module 200, in an environment with a high temperature, for example, in summer or a transitional season between spring and autumn, the battery module 200 generates a large amount of heat in the charging/discharging process. In this case, the battery module 200 usually needs to be cooled to ensure normal working of the battery module 200. However, in winter in which the temperature is low, the battery module 200 may encounter a charging/discharging fault due to the low temperature. Therefore, in this case, the battery module 200 needs to be heated to ensure normal working of the battery module 200. For the power module 300, because the power module 300 always generates a large amount of heat in a working process, the power module 300 usually needs to be cooled in time in various environmental conditions to ensure normal running of the power module 300.

Based on this, in embodiments of this application, the energy storage device may include a first cold plate and a second cold plate. The first cold plate is configured to perform heat exchange with a first load of the energy storage device, and the second cold plate is configured to perform heat exchange with a second load of the energy storage device. For example, the first load is the power module 300, and the second load is the battery module 200. In an implementation, the first cold plate and the power module 300 may be independent of each other, and the first cold plate is in heat conduction contact with the power module 300, to dissipate heat for the power module 300. In another implementation, the first cold plate may alternatively be integrated into the power module 300. Similarly, the second cold plate may be independent of the battery module 200, or the second cold plate may be integrated into the battery module 200.

In addition, the energy storage device further includes a thermal management system. The thermal management system may adjust, in a plurality of running modes, temperatures of coolant flowing through the first cold plate and the second cold plate, to implement thermal management on the power module 300 and the battery module 200, and improve running energy efficiency of the energy storage device 1000. To make the objectives, technical solutions, and advantages of this application clearer, the following further describes a thermal management system 400 provided in embodiments of this application in detail with reference to the accompanying drawings and specific embodiments.

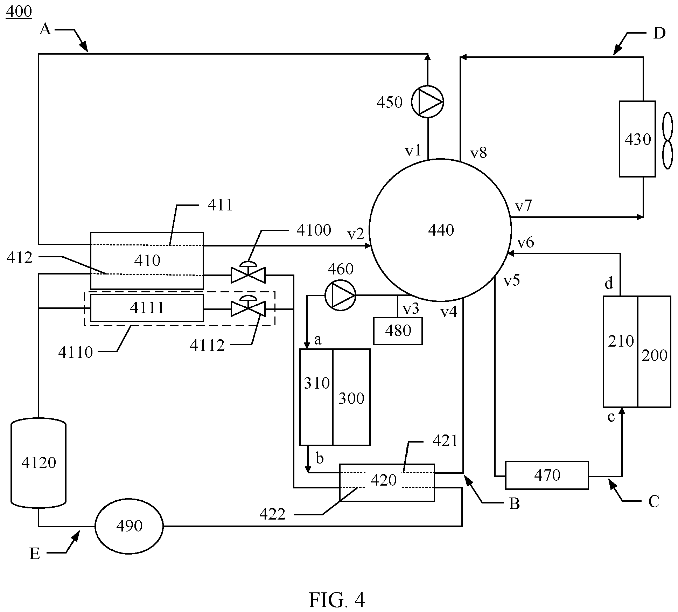

FIG. 4 is a diagram of a structure of the thermal management system 400 according to an embodiment of this application. In embodiments of this application, the thermal management system 400 includes a first path A, a second path B, a third path C, a fourth path D, and a multi-way valve 440. The first path A, the second path B, the third path C, and the fourth path D are all configured to flow coolant. For example, the coolant includes water, a glycol solution, and the like. The multi-way valve 440 may be configured to communicate paths of the thermal management system 400 with the first cold plate 310 and the second cold plate 210 of the energy storage device in specific manners, so that the thermal management system 400 implements a plurality of working modes, and satisfies cooling or heating requirements of a first load and a second load of the energy storage device. It should be noted that in the following embodiments, an example in which the first load is the power module 300 and the second load is the battery module 200 is used for description.

In an embodiment, the first path A includes a coolant flow channel 411 of an evaporator 410, an inlet of the first path A may be connected to an inlet of the coolant flow channel 411 of the evaporator 410, and an outlet of the coolant flow channel 411 of the evaporator 410 may be connected to an outlet of the first path A.

In an embodiment, the second path B includes a coolant flow channel 421 of a condenser 420, a first liquid outlet a, and a first liquid inlet b. An inlet of the second path B may be connected to the first liquid outlet a, the first liquid inlet b may be connected to an inlet of the coolant flow channel 421 of the condenser 420, and an outlet of the coolant flow channel 421 of the condenser 420 may be connected to an outlet of the second path B. In addition, the first liquid outlet a and the first liquid inlet b may be separately used as pipeline ports inside the second path B. The first liquid outlet a is configured to connect to a liquid inlet of the first cold plate 320, and the first liquid inlet b is configured to connect to a liquid outlet of the first cold plate 320, so that the first cold plate 310 can be connected to the second path in this manner.

In an embodiment, the third path C includes a second liquid outlet c and a second liquid inlet d, an inlet of the third path C may be connected to the second liquid outlet c, and the second liquid inlet d may be connected to an outlet of the third path C. In addition, the second liquid outlet c and the second liquid inlet d may be separately used as pipeline ports inside the third path C. The second liquid outlet c is configured to communicate with a liquid inlet of the second cold plate 210, and the second liquid inlet d is configured to communicate with a liquid outlet of the second cold plate 210, so that the second cold plate 210 can be connected to the third path C.

In an embodiment, the fourth path D includes a heat exchanger 430, an inlet of the fourth path D is connected to an inlet of the heat exchanger 430, and an outlet of the heat exchanger 430 is connected to an outlet of the fourth path D. The heat exchanger 430 may be an air/liquid heat exchanger, and coolant in the heat exchanger 430 may perform heat exchange with air flowing through a surface of the heat exchanger 430.

Still refer to FIG. 4. In this embodiment, the multi-way valve 440 may include eight ports, that is, the multi-way valve 440 is an eight-way valve. For ease of description, the eight ports of the multi-way valve are respectively referred to as a first port v1, a second port v2, a third port v3, a fourth port v4, a fifth port v5, a sixth port v6, a seventh port v7, and an eighth port v8 in the following. In a specific implementation, the first port v1 and the second port v2 may be respectively connected to the inlet of the first path A and the outlet of the first path A; the third port v3 and the fourth port v4 may be respectively connected to the inlet and the outlet of the second path B; the fifth port v5 and the sixth port v6 may be respectively connected to the inlet and the outlet of the third path C; and the seventh port v7 and the eighth port v8 may be respectively connected to the inlet and the outlet of the fourth path D.

In other words, every two ports of the multi-way valve 440 are configured to connect to one path. In this way, different modes of connection between the four paths can be implemented by controlling a status of communication between the ports of the multi-way valve 440, so that a plurality of different circulation loops are formed between the four paths, to provide a feasible condition for the thermal management system 400 to implement a plurality of working modes. In addition, the multi-way valve 440 is configured to establish connection relationships between the four paths, so that integration of the thermal management system 400 can be improved, and connection pipelines of the thermal management system 400 can be simplified. This helps improve energy efficiency of the thermal management system 400.

In this embodiment of this application, the multi-way valve 440 may further include a valve plug. The valve plug may be disposed in the multi-way valve 440 in a movable manner to communicate or disconnect different ports for the multi-way valve 440, to switch connection manners of the foregoing four modules, and connect the four modules to a same loop or different loops in a plurality of manners. The following describes circulation loops of the thermal management system 400 when the multi-way valve 440 is in different connection states.

In a specific implementation, the multi-way valve 440 is configured to communicate the first port v1 with the sixth port v6 or connect the first port v1 to the eighth port v8; the multi-way valve 440 is configured to communicate the second port v2 with the fifth port v5 or communicate the second port v2 with the seventh port v7; the multi-way valve 440 is configured to communicate the third port v3 with the eighth port v8 or communicate the third port v3 with the sixth port v6; and the multi-way valve 440 is configured to communicate the fourth port v4 with the seventh port v7 or communicate the fourth port v4 with the fifth port v5.

In a first scenario, the multi-way valve 440 is configured to communicate the first port v1 with the sixth port v6, communicate the second port v2 with the fifth port v5, communicate the third port v3 with the eighth port v8, and communicate the fourth port v4 with the seventh port v7. In this case, the first path A and the third path C may be connected to form a first circulation loop, and the second path B and the fourth path D may be connected to form a second circulation loop.

In a second scenario, the multi-way valve 440 is configured to communicate the first port v1 with the eighth port v8, communicate the second port v2 with the fifth port v5, communicate the third port v3 with the sixth port v6, and communicate the fourth port v4 with the seventh port v7. In this case, the first path A, the third path C, the second path B, and the fourth path D may be connected to form a third circulation loop.

In a third scenario, the multi-way valve 440 is configured to communicate the first port v1 with the eighth port v8, communicate the second port v2 with the seventh port v7, communicate the third port v3 with the sixth port v6, and communicate the fourth port v4 with the fifth port v5. In this case, the first path A and the fourth path D may be connected to form a fourth circulation loop, and the second path B and the third path C may be connected to form a fifth circulation loop.

It can be learned from the foregoing description that the first circulation loop, the second circulation loop, the third circulation loop, the fourth circulation loop, and the fifth circulation loop are all communicated through the multi-way valve 440, and each circulation loop includes at least two paths of the four paths. Therefore, heat exchange media in the five circulation loops are the same as heat exchange media in the paths, that is, the heat exchange media in the first circulation loop, the second circulation loop, the third circulation loop, the fourth circulation loop, and the fifth circulation loop are all coolant.

Still refer to FIG. 4. In this embodiment of this application, the thermal management system 400 may further include a first pump 450 and a second pump 460. The first pump 450 and the second pump 460 may be separately disposed in two of the four paths of the thermal management system 400. In addition, in the foregoing five circulation loops, each circulation loop includes at least one of the first pump 450 and the second pump 460, to drive coolant circulation in each circulation loop. Based on the foregoing considerations, in an implementation, the first pump 450 may be connected to the first path A, and the second pump 460 may be connected to the second path B. In this way, the first pump 450 may exist in the first circulation loop formed by the first path A and the third path C, the third circulation loop formed by the first path A, the second path B, the third path C, and the fourth path D, and the fourth circulation loop formed by the first path A and the fourth path D, and the second pump 460 may exist in the second circulation loop formed by the second path B and the fourth path D, the fifth circulation loop formed by the second path B and the third path C, and the third circulation loop.

In an implementation, an inlet of the first pump 450 is connected to the inlet of the first path A, and an outlet of the first pump 450 is connected to the inlet of the coolant flow channel 411 of the evaporator 410. In other words, the first pump 450 is connected between the inlet of the first path A and the inlet of the coolant flow channel 411 of the evaporator 410. In another implementation, an inlet of the first pump 450 is connected to the outlet of the coolant flow channel 411 of the evaporator 410, and an outlet of the first pump 450 is connected to the outlet of the first path A. In other words, the first pump 450 is connected between the outlet of the coolant flow channel 411 of the evaporator 410 and the outlet of the first path A.

In an implementation, an inlet of the second pump 460 is connected to the inlet of the second path B, and an outlet of the second pump 460 is connected to the first liquid outlet a. In other words, the second pump 460 is connected between the inlet of the second path B and the first liquid outlet a. In another implementation, an inlet of the second pump 460 is connected to the outlet of the coolant flow channel 421 of the condenser 420, and an outlet of the second pump 460 is connected to the outlet of the second path B. In other words, the second pump 460 is connected between the outlet of the coolant flow channel 421 of the condenser 420 and the outlet of the second path B.

In addition, in this embodiment, the thermal management system 400 may further include an electric heater 470. For example, in an implementation, the electric heater 470 may be connected to the third path C, an inlet of the electric heater 470 is connected to the inlet of the third path C, and an outlet of the electric heater 470 is connected to the second liquid outlet c. When the second cold plate 210 is connected to the third path C, the electric heater 470 may heat, in a low-temperature scenario, coolant entering the second cold plate 220, so that the second cold plate 210 transfers heat to the battery module 200, to implement a heating function for the battery module 200.

Still refer to FIG. 4. In this embodiment of this application, the thermal management system 400 further includes a liquid refill pot 480. The liquid refill pot 480 may be connected to one of the four paths. Any one of the four paths is either directly connected to another path in a same circulation loop, or is indirectly communicated with another path through another path. Therefore, the liquid refill pot 480 may perform liquid refill for any one of the foregoing five circulation loops, to satisfy coolant requirements of the thermal management system 400 in different working modes, ensure that coolant in each circulation loop is always at a good flow, and improve reliability and stability of the thermal management system 400.

In an embodiment, the liquid refill pot 480 may be connected to a path having a pump, and the liquid refill pot 480 is adjacently connected to the pump, so that the pump can fetch liquid from the liquid refill pot 480 at any time. For example, in the embodiment shown in FIG. 4, when the first pump 450 is connected to the first path A and the second pump 460 is connected to the second path B, further, the liquid refill pot 480 may be connected to the second path B. Because the power module 300 generates a large amount of heat, after the second cold plate 210 is connected to the second path B, the coolant initially heats up after the coolant flows through the second cold plate 210, and then the temperature increases again after the coolant flows through the coolant flow channel 421 of the condenser 420. Under effect of a high temperature, the coolant in the second path B has a specific expansion amount. The liquid refill pot 480 is connected to the second path B, that is, the liquid refill pot 480 may be configured to temporarily accommodate the excess coolant after expansion, to reduce a risk that a connection pipeline in the second path B is broken due to excessive pressure.

In addition, in the second path B, when the second pump 460 is connected between the inlet of the second path B and the first liquid outlet a, the liquid refill pot 480 may be disposed closer to the third port v3 instead of the second liquid outlet a, or when the second pump 460 is connected between the outlet of the coolant flow channel 421 of the condenser 420 and the outlet of the second path B, the liquid refill pot 480 may be disposed closer to the fourth port v4 instead of the outlet of the coolant flow channel 421 of the condenser 420. In this way, the liquid refill pot 480 can not only implement the foregoing liquid refill function, but also stabilizes an internal voltage of the multi-way valve 440, to improve working stability of the multi-way valve 440 in different connection states.

Still refer to FIG. 4. In this embodiment of this application, the thermal management system 400 may further include a fifth path E, and the fifth path E may be configured to flow a refrigerant. The fifth path E includes a compressor 490, an expansion valve 4100, a refrigerant flow channel 422 of the condenser 420, and a refrigerant flow channel 412 of the evaporator 410. An outlet of the compressor 490 is connected to an inlet of the refrigerant flow channel 422 of the condenser 420, an outlet of the refrigerant flow channel 422 of the condenser 420 is connected to an inlet of the refrigerant flow channel 412 of the evaporator 410 through the expansion valve 4100, and an outlet of the refrigerant flow channel 412 of the evaporator 410 is connected to an inlet of the compressor 490. In this way, the compressor 490, the refrigerant flow channel 422 of the condenser 420, the expansion valve 4100, and the refrigerant flow channel 412 of the evaporator 410 may be sequentially connected to form a circulation path. Therefore, in this embodiment, the fifth path E may also be considered as a sixth circulation loop of the thermal management system 400. For example, a refrigerant in the sixth circulation loop includes R134a, R1234yf, R744, or the like.

In addition, the thermal management system 400 may further include a dehumidification module 4110. The dehumidification module 4110 may be configured to reduce humidity inside the energy storage device, to reduce a risk of corrosion of the battery module 200, the power module 300, and another electrical component, and improve use safety and reliability of the energy storage device. An inlet of the dehumidification module 4110 may be connected to the outlet of the refrigerant flow channel 422 of the condenser 420, and the dehumidification module 4110 may be connected to the inlet of the compressor 490. In this way, the compressor 490, the refrigerant flow channel 422 of the condenser 420, and the dehumidification module 4110 may be sequentially connected to form a seventh circulation loop. A heat exchange medium in the seventh circulation loop is the same as a heat exchange medium in the sixth circulation loop, that is, the heat exchange medium in the seventh circulation loop may also be the refrigerant like R134a, R1234yf, or R744.

In a specific implementation, the dehumidification module 4110 includes an evaporator and an expansion valve. For ease of distinguishing, the evaporator and the expansion valve in the sixth circulation loop are referred to as a first evaporator 410 and a first expansion valve 4100 in the following, the evaporator and the expansion valve of the dehumidification module 4110 are referred to as a second evaporator 4111 and a second expansion valve 4112. The second evaporator 4111 may be a micro-channel heat exchanger. The outlet of the refrigerant flow channel 422 of the condenser 420 is connected to an inlet of the second evaporator 4111 through the second expansion valve 4112, and an outlet of the second evaporator 4111 is connected to the inlet of the compressor 490.

In some embodiments, the thermal management system 400 further includes a gas-liquid separator 4120, and the gas-liquid separator 4120 may be disposed at the inlet of the compressor 490. Both the outlet of the refrigerant flow channel 412 of the first evaporator 410 and the outlet of the second evaporator 4111 are connected to the inlet of the compressor 490 through the gas-liquid separator 4120, that is, the gas-liquid separator 4120 exists in both the sixth circulation loop and the seventh circulation loop. The gas-liquid separator 4120 may be configured to separate a liquid refrigerant at the inlet of the compressor 490, to reduce content of the liquid refrigerant entering the compressor 490, and may further store redundant refrigerant, to satisfy refrigerant requirements of the thermal management system 400 in different working modes, ensure that refrigerants in the sixth circulation loop and the seventh circulation loop are always at a good flow, and improve running reliability and stability of the thermal management system 400.

In this embodiment of this application, one or more circulation loops of the thermal management system 400 may be communicated by adjusting an on/off state of the compressor 490 and a communication status of the multi-way valve 440, so that the thermal management system 400 can implement a plurality of working modes. For example, these working modes include but are not limited to a compressor cooling mode, a natural heat dissipation mode, a heating mode, a compressor cooling and dehumidification mode, a natural heat dissipation and dehumidification mode, a heating and dehumidification mode, and the like. The following specifically describes a working process of the thermal management system 400 shown in FIG. 4 in the foregoing working modes.

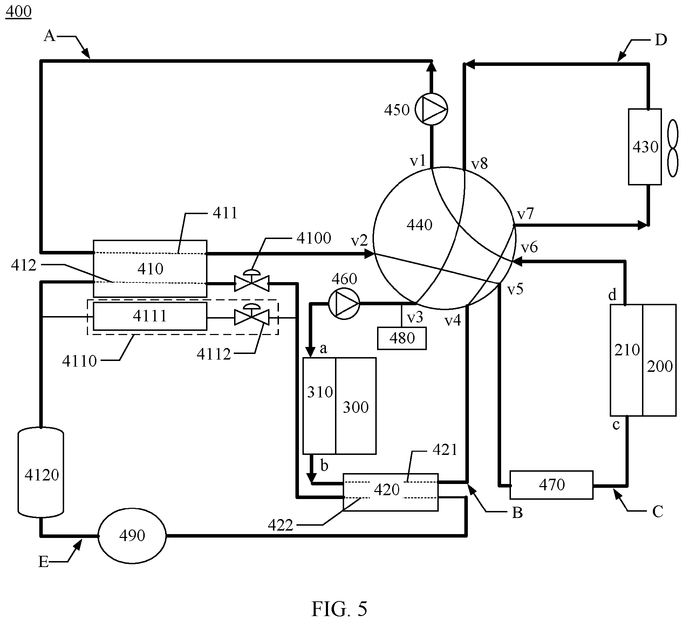

FIG. 5 is a diagram of the thermal management system 400 shown in FIG. 4 running in the compressor cooling mode. The compressor cooling mode applies to scenarios where an ambient temperature is high, for example, in summer. In this mode, the compressor 490, the first expansion valve 4100, the first pump 450, and the second pump 460 are turned on, and the second expansion valve 4112 and the electric heater 470 are turned off. In the multi-way valve 440, the first port v1 and the sixth port v6 are communicated, the second port v2 and the fifth port v5 are communicated, the third port v3 and the eighth port v8 are communicated, and the fourth port v4 and the seventh port v7 are communicated. The sixth circulation loop (the fifth path E), the first circulation loop (the loop formed by connecting the first path A to the third path C), and the second circulation loop (the loop formed by connecting the second path B to the fourth path D) run simultaneously.

In the sixth circulation loop, a high-temperature and high-pressure gaseous refrigerant output by the compressor 490 enters the refrigerant flow channel 422 of the condenser 420, and becomes a low-temperature and high-pressure liquid refrigerant after condensation heat exchange with coolant in the coolant flow channel 421 of the condenser 420. After being throttled and expanded by the first expansion valve 4100, the refrigerant rapidly cools down and becomes a low-temperature and low-pressure liquid refrigerant, and then enters the refrigerant flow channel 412 of the first evaporator 410 to perform evaporative heat exchange with coolant in the coolant flow channel 411 of the first evaporator 410. After evaporative heat exchange, the refrigerant becomes a high-temperature and low-pressure gaseous refrigerant and returns to the compressor 490 again, to complete one time of circulation.

In the first circulation loop, the coolant in the coolant flow channel 411 of the first evaporator 410 exchanges heat for cooling with a low-temperature refrigerant in the refrigerant flow channel 412 of the first evaporator 410 and then enters the second cold plate 210. After the coolant exchanges heat for heating with the battery module 200 in the second cold plate 210, under driving of the first pump 450, the coolant returns to the coolant flow channel 411 of the first evaporator 410 again, and the battery module 200 transfers heat to the coolant in the second cold plate 210, to implement cooling.

In the second circulation loop, the coolant in the coolant flow channel 421 of the condenser 420 exchanges heat for heating with a high-temperature refrigerant in the refrigerant flow channel 422 of the condenser 420, and then enters the heat exchanger 430. The coolant cools down in the heat exchanger 430 after exchanging heat with the air flowing through the surface of the heat exchanger 430, and then enters the first cold plate 310 under driving of the second pump 460. After preliminarily exchanging heat with the power module 300 in the first cold plate 310, the coolant returns to the coolant flow channel 421 of the condenser 420 again, and further exchanges heat with the high-temperature refrigerant in the refrigerant flow channel 422 of the condenser 420, to complete one time of circulation. In this process, the power module 300 may transfer heat to the coolant in the first cold plate 310 to implement heat dissipation and cooling. Although a temperature of the coolant increases after heat exchange with the power module 300, the coolant is still in a low temperature range. Therefore, a cooling capacity may be further transferred to the refrigerant in the first circulation loop by using the condenser 420.

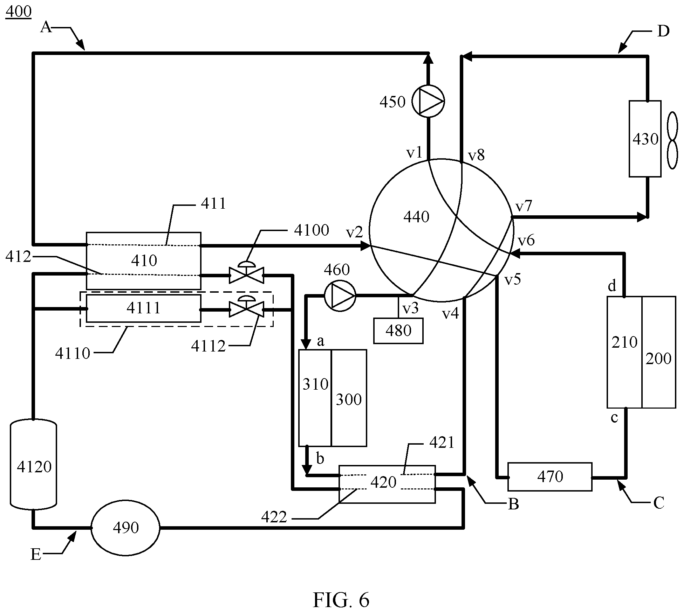

FIG. 6 is a diagram of the thermal management system 400 shown in FIG. 4 running in a compressor cooling and dehumidification mode. The compressor cooling and dehumidification mode applies to scenarios where an ambient temperature is high and dehumidification is required. In this mode, the compressor 490, the first expansion valve 4100, the second expansion valve 4112, the first pump 450, and the second pump 460 are turned on, and the electric heater 470 is turned off. In the multi-way valve 440, the first port v1 and the sixth port v6 are communicated, the second port v2 and the fifth port v5 are communicated, the third port v3 and the eighth port v8 are communicated, and the fourth port v4 and the seventh port v7 are communicated. The sixth circulation loop (the fifth path E), the seventh circulation loop (the loop formed by connecting the compressor 490, the refrigerant flow channel 422 of the condenser 420, the second expansion valve 4112, and the second evaporator 4111), the first circulation loop (the loop formed by connecting the first path A and the third path C), and the second circulation loop (the loop formed by connecting the second path B and the fourth path D) run simultaneously.

For working processes of the sixth circulation loop, the first circulation loop, and the second circulation loop, refer to related descriptions in the foregoing compressor cooling mode. Details are not described herein.

In the seventh circulation loop, a high-temperature and high-pressure gaseous refrigerant output by the compressor 490 enters the refrigerant flow channel 422 of the condenser 420, and becomes a low-temperature and high-pressure liquid refrigerant after condensation heat exchange with coolant in the coolant flow channel 421 of the condenser 420. After being throttled and expanded by the second expansion valve 4112, the refrigerant rapidly cools down and becomes a low-temperature and low-pressure liquid refrigerant, and then enters the second evaporator 4111 to perform evaporative heat exchange with air flowing through a surface of the second evaporator in the second evaporator 4111. After evaporative heat exchange, the refrigerant becomes a high-temperature and low-pressure gaseous refrigerant and returns to the compressor 490 again, to complete one time of circulation. In this process, when the air flowing through the surface of the second evaporator 4111 exchanges heat with the refrigerant in the second evaporator 4111, if a temperature of the surface of the second evaporator 4111 is lower than a dew point temperature of the air, moisture in the air is cooled and condensed. Condensed water is discharged through a drainpipe of the energy storage device, to achieve dehumidification effect inside the energy storage device.

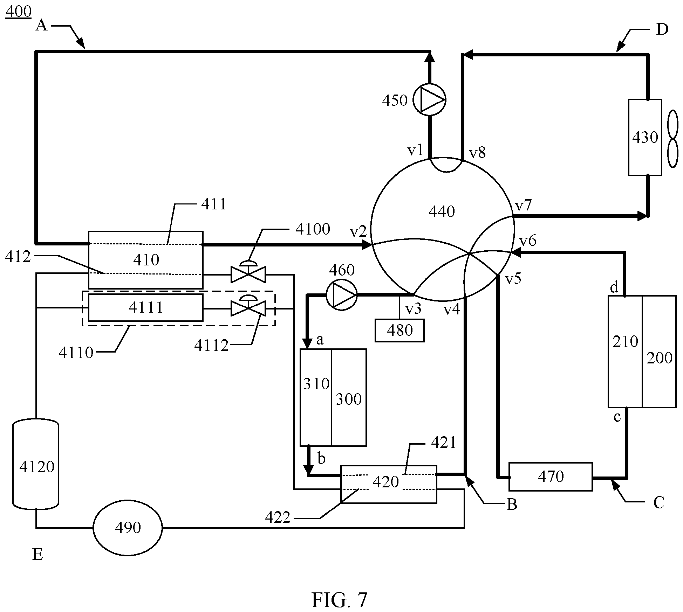

FIG. 7 is a diagram of the thermal management system 400 shown in FIG. 4 running in a natural heat dissipation mode. The natural heat dissipation mode applies to scenarios where an ambient temperature is moderate, for example, in spring or autumn. In this mode, the compressor 490, the first expansion valve 4100, the second expansion valve 4112, and the electric heater 470 are turned off, and the first pump 450 and the second pump 460 are turned on. In the multi-way valve 440, the first port v1 and the eighth port v8 are communicated, the second port v2 and the fifth port v5 are communicated, the third port v3 and the sixth port v6 are communicated, and the fourth port v4 and the seventh port v7 are communicated. The third circulation loop (the loop formed by connecting the first path A, the third path C, the second path B, and the fourth path D) runs.

In the third circulation loop, the coolant in the heat exchanger 430 exchanges heat for cooling with the air flowing through the surface of the heat exchanger, and then enters the coolant flow channel 411 of the first evaporator 410 under driving of the first pump 450. Then, the coolant enters the second cold plate 210 from the coolant flow channel 411 of the first evaporator 410, preliminarily exchanges heat with the battery module 200 in the second cold plate 210, and takes away heat of the battery module 200. The coolant enters the first cold plate 310 under driving of the second pump 460, and after exchanging heat with the power module 300 in the first cold plate 310, the coolant takes away heat of the power module 300. After heat exchange for heating, the coolant enters the heat exchanger 430 again through the coolant flow channel 421 of the condenser 420, to complete one time of circulation. In this process, the battery module 200 and the power module 300 implement heat dissipation and cooling by transferring heat to the coolant. In addition, the coolant flow channel 411 of the first evaporator 410 and the coolant flow channel 421 of the condenser 420 may be considered as a flow pipe in this loop, and do not perform a heat exchange function.

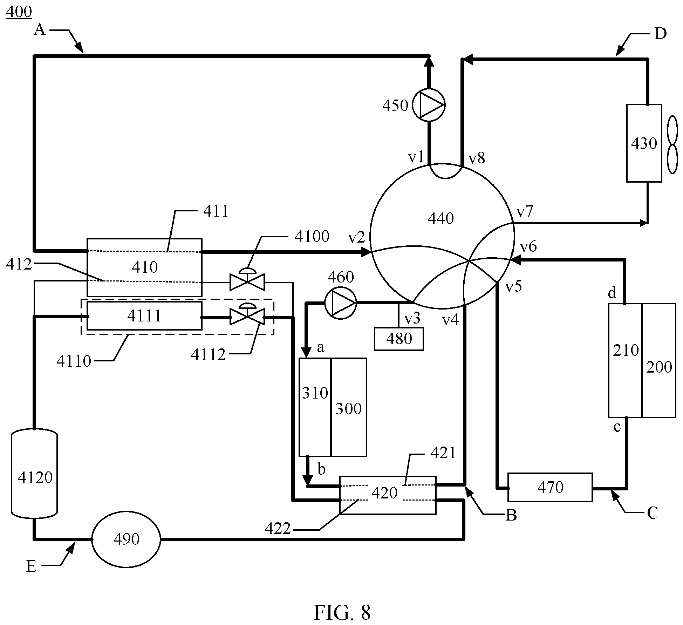

FIG. 8 is a diagram of the thermal management system 400 shown in FIG. 4 running in a natural heat dissipation and dehumidification mode. The natural heat dissipation dehumidification mode applies to scenarios where an ambient temperature is moderate and dehumidification is required. In this mode, the compressor 490, the second expansion valve 4112, the first pump 450, and the second pump 460 are turned on, and the first expansion valve 4100 and the heater 470 are turned off. In the multi-way valve 440, the first port v1 and the eighth port v8 are communicated, the second port v2 and the fifth port v5 are communicated, the third port v3 and the sixth port v6 are communicated, and the fourth port v4 and the seventh port v7 are communicated. The third circulation loop (the loop formed by connecting the first path A, the third path C, the second path B, and the fourth path D) and the seventh circulation loop (the loop formed by connecting the compressor 490, the refrigerant flow channel 422 of the condenser 420, the second expansion valve 4112, and the second evaporator 4111) run simultaneously. For a working process of the seventh circulation loop, refer to related descriptions in the foregoing compressor cooling and dehumidification mode. Details are not described herein.

In the third circulation loop, the coolant in the heat exchanger 430 exchanges heat for cooling with the air flowing through the surface of the heat exchanger, and then enters the coolant flow channel 411 of the first evaporator 410 under driving of the first pump 450. Then, the coolant enters the second cold plate 210 from the coolant flow channel 411 of the first evaporator 410, preliminarily exchanges heat with the battery module 200 in the second cold plate 210, and takes away heat of the battery module 200. The coolant enters the first cold plate 310 under driving of the second pump 460, and after exchanging heat with the power module 300 in the first cold plate 310, the coolant takes away heat of the power module 300. The coolant then enters the coolant flow channel 421 of the condenser 420, further exchanges heat in the first path 421 of the condenser 420 with the high-temperature refrigerant in the refrigerant flow channel 422 of the condenser 420, and finally returns to the heat exchanger 430 again. In addition, the coolant flow channel 411 of the first evaporator 410 may be considered as a flow pipe in this loop, and does not perform a heat exchange function.

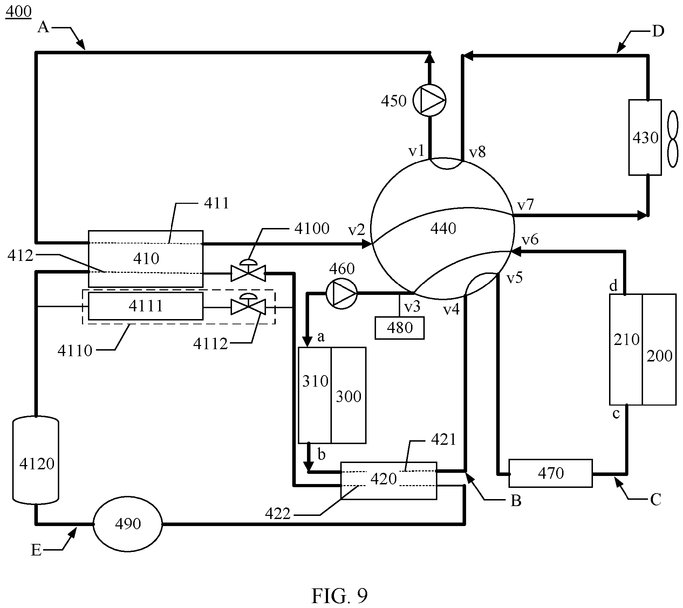

FIG. 9 is a diagram of the thermal management system 400 shown in FIG. 4 running in a heating mode. The heating mode applies to scenarios where an ambient temperature is low, for example, in winter. In this mode, the compressor 490, the first expansion valve 4100, the first pump 450, and the second pump 460 are turned on, and the second expansion valve 4112 is turned off. In multi-way valve 440, the first port v1 and the eighth port v8 are communicated, the second port v2 and the seventh port v7 are communicated, the third port v3 and the sixth port v6 are communicated, and the fourth port v4 and the fifth port v5 are communicated. The sixth circulation loop (the fifth path E), the fourth circulation loop (the loop formed by connecting the first path A and the fourth path D), and the fifth circulation loop (the loop formed by connecting the second path B and the third path C) run simultaneously. For a working process of the sixth circulation loop, refer to related descriptions in the foregoing compressor cooling mode. Details are not described herein.

In the fourth circulation loop, the coolant in the coolant flow channel 411 of the first evaporator 410 exchanges heat for cooling with the low-temperature refrigerant in the refrigerant flow channel 412 of the first evaporator 410, and then enters the heat exchanger 430. The coolant heats up in the heat exchanger 430 after exchanging heat with the air flowing through the surface of the heat exchanger 430, and then returns to the coolant flow channel 411 of the first evaporator 410 again under driving of the first pump 450, to complete one time of circulation.

In the fifth circulation loop, the coolant in the coolant flow channel 421 of the condenser 420 exchanges heat for heating with the high-temperature refrigerant in the refrigerant flow channel 422 of the condenser 420, and then enters the second cold plate 210. The coolant cools down after exchanging heat with the battery module 200 in the second cold plate 210, then enters the first cold plate 310 under driving of the second pump 460, and takes away heat of the power module 300 after exchanging heat with the power module 300 in the first cold plate 310. Finally, the coolant returns to the coolant flow channel 421 of the condenser 420 again, to complete one time of circulation. In this process, the power module 300 implements heat dissipation and cooling by transferring heat to the coolant, and the battery module 200 implements heating by absorbing heat of the coolant. Therefore, the fifth circulation loop can further implement heating for the battery module 200 to some extent by using residual heat generated by the power module 300, to reduce energy waste of the energy storage device.

In addition, when the thermal management system 400 is in a heating mode, the electric heater 470 may be turned on or turned off. This may be specifically determined based on a heating requirement of the battery module 200. For example, when the heating requirement of the battery module 200 is small, the electric heater 470 may be in an off state. In this case, all heat required by the battery module 200 is provided by the condenser 420 and the power module 300. The electric heater 470 is equivalent to a flow pipe and does not perform a heating function. When the heating requirement of the battery module 200 is large, the electric heater 470 may be in an on state. After performing heat exchange for heating with the refrigerant in the refrigerant flow channel 422 of the condenser 420, the coolant in the coolant flow channel 421 of the condenser 420 enters the electric heater 470 and is further heated, and then enters the second cold plate 210 to exchange heat with the battery module 200. It should be noted that when the electric heater 470 is in the on state, a heating temperature of the electric heater 470 may be further controlled by adjusting power the electric heater 470, so that a temperature of the battery module 200 can be controlled accurately.

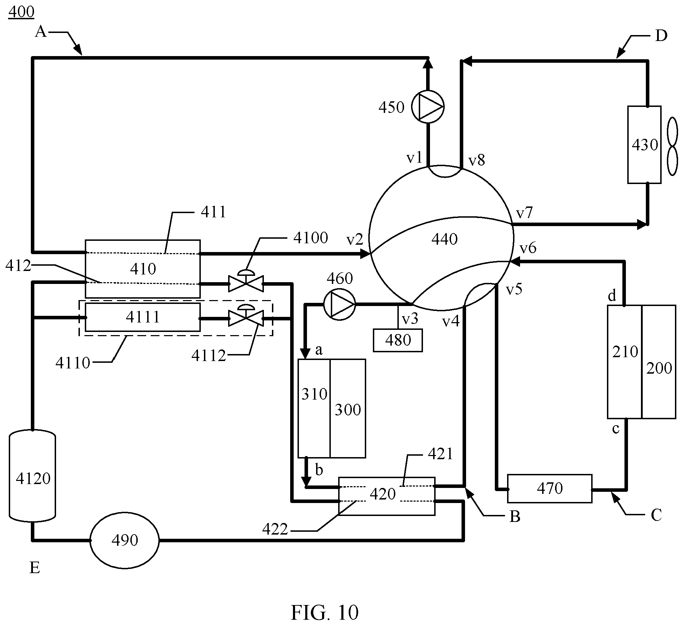

FIG. 10 is a diagram of the thermal management system 400 shown in FIG. 4 running in a heating and dehumidification mode. The heating and dehumidification mode applies to scenarios where an ambient temperature is low and dehumidification is required. In this mode, the compressor 490, the first expansion valve 4100, the second expansion valve 4112, the first pump 450, and the second pump 460 are turned on. In the multi-way valve 440, the first port v1 and the eighth port v8 are communicated, the second port v2 and the seventh port v7 are communicated, the third port v3 and the sixth port v6 are communicated, and the fourth port v4 and the fifth port v5 are communicated. The sixth circulation loop (the fifth path E), the seventh circulation loop (the loop formed by connecting the compressor 490, the refrigerant flow channel 422 of the condenser 420, the second expansion valve 4112, and the second evaporator 4111), the fourth circulation loop (the loop formed by connecting the first path A and the fourth path D), and the fifth circulation loop (the loop formed by connecting the second path B and the third path C) run simultaneously. For a working process of the sixth circulation loop, refer to related descriptions in the foregoing compressor cooling mode. For a working process of the seventh circulation loop, refer to related descriptions in the foregoing compressor cooling and dehumidification mode. For working processes of the fourth circulation loop and the fifth circulation loop, refer to related descriptions in the foregoing heating mode.

Similarly, when the thermal management system 400 is in the heating and dehumidification mode, the heater 470 may be turned on or turned off. This may be specifically determined based on the heating requirement of the battery module 200. Details are not described herein.

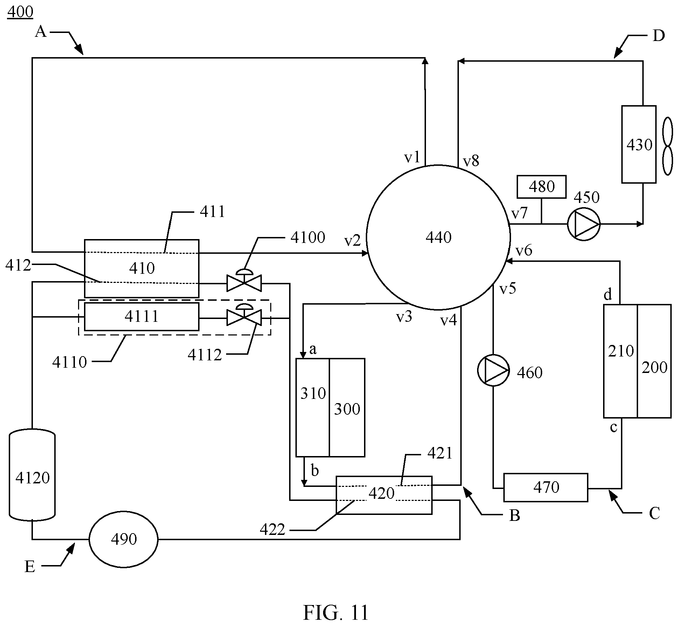

FIG. 11 is a diagram of a structure of another thermal management system 400 according to an embodiment of this application. In this embodiment of this application, the thermal management system 400 may include a multi-way valve 440, a first path A, a second path B, a third path C, a fourth path D, a fifth path E, and a dehumidification module 4110. The multi-way valve 440, the dehumidification module 4110, and a first evaporator 410, a condenser 420, a heat exchanger 430, an electric heater 470, a compressor 490, a first expansion valve 4100, and a gas-liquid separator 4120 in the plurality of paths are substantially the same in structures and disposition manners as those in the embodiment shown in FIG. 4. These components are not described in detail herein.

Different from that in the embodiment shown in FIG. 4, in this embodiment of this application, locations of a first pump 450 and a second pump 460 are adjusted. Specifically, the first pump 450 may be connected to the fourth path D, and the second pump 460 may be connected to the third path C. In this way, the first pump 450 may exist in the second circulation loop formed by the second path B and the fourth path D, the third circulation loop formed by the first path A, the second path B, the third path C, and the fourth path D, and the fourth circulation loop formed by the first path A and the fourth path D, and the second pump 460 may exist in the first circulation loop formed by the first path A and the third path C, the fifth circulation loop formed by the second path B and the third path C, and the third circulation loop. Therefore, in this connection manner, circulation loops associated with the multi-way valve 440 each may also include at least one of the first pump 450 and the second pump 460, to ensure working efficiency of the circulation loops.

In an implementation, an inlet of the first pump 450 is connected to an inlet of the fourth path D, and an outlet of the first pump 450 is connected to an inlet of the heat exchanger 430. In other words, the first pump 450 is connected between the inlet of the fourth path D and the inlet of the heat exchanger 430. In another implementation, an inlet of the first pump 450 is connected to an outlet of the heat exchanger 430, and an outlet of the first pump 450 is connected to an outlet of the fourth path D. In other words, the first pump 450 is connected between the outlet of the heat exchanger 430 and the outlet of the fourth path D.

In an implementation, an inlet of the second pump 460 is connected to an inlet of the third path C, and an outlet of the second pump 460 is connected to a second liquid outlet c. In other words, the second pump 460 is connected between the inlet of the third path C and the second liquid outlet c. It should be noted that, when the third path C includes the electric heater 470, the second pump 460 is connected between the inlet of the third path C and an inlet of the electric heater 470. In another implementation, an inlet of the second pump 460 is connected to a second liquid inlet d, and an outlet of the second pump 460 is connected to an outlet of the third path C. In other words, the second pump 460 is connected between the second liquid inlet d and the outlet of the third path C.

In this embodiment of this application, a liquid refill pot 480 may be connected to the fourth path D in which the first pump 450 is located. Because the heat exchanger 430 is a main heat exchanger component in the thermal management system 400, a temperature of coolant changes greatly after the coolant flows through the heat exchanger 430. Therefore, coolant in the fourth path D also undergoes thermal expansion and contraction due to temperature change. The liquid refill pot 480 is connected to the fourth path D, so that the liquid refill pot 480 may be used to compensate for a change amount of the coolant due to the thermal expansion and contraction, to ensure that a pressure in the fourth path D can be maintained within a safe range.

In addition, in the fourth path D, when the first pump 450 is connected between the inlet of the fourth path D and the inlet of the heat exchanger 430, the liquid refill pot 480 may be disposed closer to the seventh port v7 instead of the inlet of the heat exchanger 430; or when the first pump 450 is connected between the outlet of the heat exchanger 430 and the outlet of the fourth path D, the liquid refill pot 480 may be disposed closer to the eighth port v8 instead of the outlet of the heat exchanger 430. In this way, the liquid refill pot 480 can not only implement the foregoing liquid refill function, but also stabilizes an internal voltage of the multi-way valve 440, to improve working stability of the multi-way valve 440 in different connection states.

In an embodiment shown in FIG. 11, a status of communication between the ports of the multi-way valve 440 may alternatively be set with reference to the embodiment shown in FIG. 4, so that the thermal management system 400 implements a plurality of working modes such as a compressor cooling mode, a natural heat dissipation mode, a heating mode, a compressor cooling and dehumidification mode, a natural heat dissipation and dehumidification mode, and a heating and dehumidification mode. For a specific working process of each working mode, refer to the description in the foregoing embodiments. Details are not described herein.

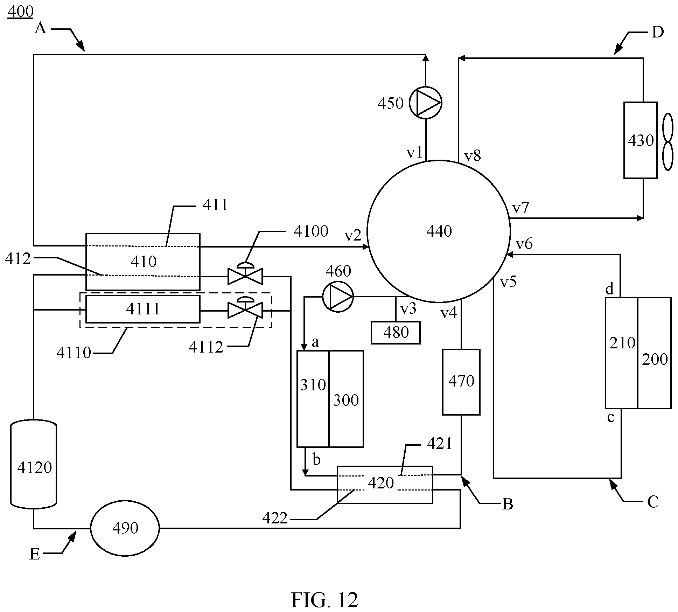

FIG. 12 is a diagram of a structure of another thermal management system 400 according to an embodiment of this application. In this embodiment of this application, the thermal management system 400 may include a multi-way valve 440, a first path A, a second path B, a third path C, a fourth path D, a fifth path E, and a dehumidification module 4110. In addition to an electric heater 470, structures and disposition manners of the multi-way valve 440 and other components in the foregoing plurality of paths may be designed with reference to the embodiment shown in FIG. 4 or FIG. 11. Details of these components are not described herein.

In this embodiment, the electric heater 470 may be connected to the second path B, an inlet of the electric heater 470 is connected to an outlet of a coolant flow channel 421 of a condenser 420, and an outlet of the electric heater 470 is connected to an outlet of the second path B. In this way, in a third scenario in which the multi-way valve 440 communicates a third port v3 with a sixth port v6, and a fourth port v4 with a fifth port v5, the electric heater 470 is connected to a fifth circulation loop formed by the second path B and the third path C. It can be learned from the foregoing working process of the thermal management system 400 in the working modes that, generally, the electric heater 470 may be turned on only when the fifth circulation loop runs in the heating mode and the heating and dehumidification mode, and the electric heater 470 is turned off in other working modes. Therefore, in this embodiment, the electric heater 470 is connected to the second path B, so that the electric heater 470 is located upstream of a second cold plate 210, and can also heat coolant entering the second cold plate 210. Then, the second cold plate 210 transfers heat to a battery module 200, to implement a heating function for the battery module 200.

In an embodiment shown in FIG. 12, a status of communication between the ports of the multi-way valve 440 may alternatively be set with reference to the embodiment shown in FIG. 4, so that the thermal management system 400 implements a plurality of working modes such as a compressor cooling mode, a natural heat dissipation mode, a heating mode, a compressor cooling and dehumidification mode, a natural heat dissipation and dehumidification mode, and a heating and dehumidification mode. For a specific working process of each working mode, refer to the description in the foregoing embodiments. Details are not described herein.

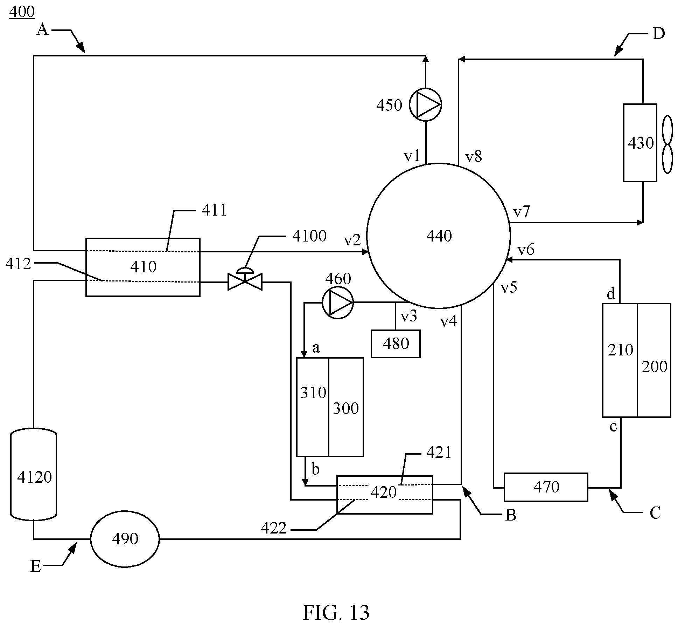

FIG. 13 is a diagram of a structure of another thermal management system 400 according to an embodiment of this application. In this embodiment of this application, the thermal management system 400 may include a multi-way valve 440, a first path A, a second path B, a third path C, a fourth path D, and a fifth path E. Structures and disposition manners of the multi-way valve 440 and the components in the foregoing plurality of paths may be designed with reference to the embodiment shown in FIG. 4 or FIG. 11. Details of these components are not described herein.

Different from that in the foregoing embodiments, in this embodiment, no dehumidification module is disposed in the thermal management system 400. Therefore, the thermal management system 400 may implement a compressor cooling mode, a natural heat dissipation mode, and a heating mode. For a communication status of the multi-way valve in the three working modes, refer to statuses of the multi-way valve 440 in corresponding modes in the embodiment shown in FIG. 4. Details are not described herein.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A thermal management system, comprising a first path, a second path, a third path, a fourth path, and a multi-way valve, wherein the first path, the second path, the third path, and the fourth path are all configured to flow coolant, and the multi-way valve comprises a first port, a second port, a third port, a fourth port, a fifth port, a sixth port, a seventh port, and an eighth port;
the first port and the second port are respectively connected to an inlet and an outlet of the first path, the first path comprises a coolant flow channel of an evaporator, the inlet of the first path is connected to an inlet of the coolant flow channel of the evaporator, and an outlet of the coolant flow channel of the evaporator is connected to the outlet of the first path;
the third port and the fourth port are respectively connected to an inlet and an outlet of the second path, the second path comprises a coolant flow channel of a condenser, a first liquid outlet, and a first liquid inlet, the first liquid outlet is configured to connect to a liquid inlet of a first cold plate, the first liquid inlet is configured to connect to a liquid outlet of the first cold plate, the inlet of the second path is connected to the first liquid outlet, the first liquid inlet is connected to an inlet of the coolant flow channel of the condenser, and an outlet of the coolant flow channel of the condenser is connected to the outlet of the second path;
the fifth port and the sixth port are respectively connected to an inlet and an outlet of the third path, the third path comprises a second liquid outlet and a second liquid inlet, the second liquid outlet is configured to connect to a liquid inlet of a second cold plate, the second liquid inlet is configured to connect to a liquid outlet of the second cold plate, the inlet of the third path is connected to the second liquid outlet, and the second liquid inlet is connected to an outlet of the third path;
the seventh port and the eighth port are respectively connected to an inlet and an outlet of the fourth path, the fourth path comprises a heat exchanger, the inlet of the fourth path is connected to an inlet of the heat exchanger, and an outlet of the heat exchanger is connected to the outlet of the fourth path; and
the multi-way valve is configured to communicate the first port with the sixth port or communicate the first port with the eighth port, the multi-way valve is configured to communicate the second port with the fifth port or communicate the second port with the seventh port, the multi-way valve is configured to communicate the third port with the eighth port or communicate the third port with the sixth port, and the multi-way valve is configured to communicate the fourth port with the seventh port or communicate the fourth port with the fifth port.

2. The thermal management system according to claim 1, wherein the thermal management system further comprises a first pump and a second pump;
the first pump is connected to the first path, an inlet of the first pump is connected to the inlet of the first path, and an outlet of the first pump is connected to the inlet of the coolant flow channel of the evaporator, or an inlet of the first pump is connected to the outlet of the coolant flow channel of the evaporator, and an outlet of the first pump is connected to the outlet of the first path; and
the second pump is connected to the second path, an inlet of the second pump is connected to the inlet of the second path, and an outlet of the second pump is connected to the first liquid outlet, or an inlet of the second pump is connected to the outlet of the coolant flow channel of the condenser, and an outlet of the second pump is connected to the outlet of the second path.

3. The thermal management system according to claim 1, wherein the thermal management system further comprises a first pump and a second pump;
the first pump is connected to the fourth path, an inlet of the first pump is connected to the inlet of the fourth path, and an outlet of the first pump is connected to the inlet of the heat exchanger, or an inlet of the first pump is connected to the outlet of the heat exchanger, and an outlet of the first pump is connected to the outlet of the fourth path; and
the second pump is connected to the third path, an inlet of the second pump is connected to the inlet of the third path, and an outlet of the second pump is connected to the second liquid outlet, or an inlet of the second pump is connected to the second liquid inlet, and an outlet of the second pump is connected to the outlet of the third path.

4. The thermal management system according to any one of claims 1 to 3, wherein the thermal management system further comprises a liquid refill pot, the liquid refill pot is connected to the second path, and the liquid refill pot is closer to the third port than the second liquid outlet, or the liquid refill pot is closer to the fourth port than the outlet of the coolant flow channel of the condenser; or
the liquid refill pot is connected to the fourth path, and the liquid refill pot is closer to the seventh port than the inlet of the heat exchanger, or the liquid refill pot is closer to the eighth port than the outlet of the heat exchanger.

5. The thermal management system according to any one of claims 1 to 4, wherein the thermal management system further comprises an electric heater, the electric heater is connected to the third path, an inlet of the electric heater is connected to the inlet of the third path, and an outlet of the electric heater is connected to the second liquid outlet.

6. The thermal management system according to any one of claims 1 to 4, wherein the thermal management system further comprises an electric heater, the electric heater is connected to the second path, an inlet of the electric heater is connected to the outlet of the coolant flow channel of the condenser, and an outlet of the electric heater is connected to the outlet of the second path.

7. The thermal management system according to any one of claims 1 to 6, wherein the thermal management system further comprises a fifth path, the fifth path is configured to flow a refrigerant, the fifth path comprises a compressor, an expansion valve, a refrigerant flow channel of the condenser, and a refrigerant flow channel of the evaporator, an outlet of the compressor is connected to an inlet of the refrigerant flow channel of the condenser, an outlet of the refrigerant flow channel of the condenser is connected to an inlet of the refrigerant flow channel of the evaporator through the expansion valve, and an outlet of the refrigerant flow channel of the evaporator is connected to an inlet of the compressor.

8. The thermal management system according to claim 7, wherein the thermal management system further comprises a dehumidification module, an inlet of the dehumidification module is connected to the outlet of the refrigerant flow channel of the condenser, and an outlet of the dehumidification module is connected to the inlet of the compressor.

9. The thermal management system according to any one of claims 1 to 8, wherein in a first scenario, the multi-way valve is configured to communicate the first port with the sixth port, communicate the second port with the fifth port, communicate the third port with the eighth port, and communicate the fourth port with the seventh port; and
the first path and the third path are connected to form a first circulation loop, and the second path and the fourth path are connected to form a second circulation loop.

10. The thermal management system according to any one of claims 1 to 8, wherein in a second scenario, the multi-way valve is configured to communicate the first port with the eighth port, communicate the second port with the fifth port, communicate the third port with the sixth port, and communicate the fourth port with the seventh port; and
the first path, the third path, the second path, and the fourth path are connected to form a third circulation loop.

11. The thermal management system according to any one of claims 1 to 8, wherein in a third scenario, the multi-way valve is configured to communicate the first port with the eighth port, communicate the second port with the seventh port, communicate the third port with the sixth port, and communicate the fourth port with the fifth port; and
the first path and the fourth path are connected to form a fourth circulation loop, and the second path and the third path are connected to form a fifth circulation loop.

12. An energy storage device, comprising a first load, a second load, a first cold plate, a second cold plate, and the thermal management system according to any one of claims 1 to 11, wherein
the first liquid outlet is connected to a liquid inlet of the first cold plate, the first liquid inlet is connected to a liquid outlet of the first cold plate, and the first cold plate is configured to perform heat exchange with the first load; and
the second liquid outlet is connected to a liquid inlet of the second cold plate, the second liquid inlet is connected to a liquid outlet of the second cold plate, and the second cold plate is configured to perform heat exchange with the second load.

13. The energy storage device according to claim 12, wherein the first load is a power module, and the second load is a battery module.

14. A photovoltaic energy storage system, comprising a photovoltaic power generation device, a power conversion device, and the energy storage device according to claim 12 or 13, wherein the power conversion device is connected between the photovoltaic power generation device and the energy storage device;
the photovoltaic power generation device is configured to generate a direct current; and
the power conversion device is configured to: convert the direct current generated by the photovoltaic power generation device into an alternating current, and transmit the alternating current to the energy storage device.
